(19) Europäisches Patentamt
European Patent Office
Office européen des brevets

(11) **EP 4 700 652 A1**

(12) **EUROPEAN PATENT APPLICATION**
published in accordance with Art. 153(4) EPC

(43) Date of publication:
**25.02.2026 Bulletin 2026/09**

(21) Application number: **24792128.1**

(22) Date of filing: **19.04.2024**

(51) International Patent Classification (IPC):
**G06N 3/04** (2023.01)    **G06F 30/27** (2020.01)
**G06N 20/00** (2019.01)    **G06N 3/08** (2023.01)
**G06F 111/10** (2020.01)

(52) Cooperative Patent Classification (CPC):
**G06F 30/27; G06N 3/04; G06N 3/08; G06N 20/00;**
G06F 2111/10

(86) International application number:
**PCT/CN2024/088822**

(87) International publication number:
**WO 2024/217543 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.04.2023 CN 202310431810**

(71) Applicant: **Shanghai Jiao Tong University**
**Shanghai 200240 (CN)**

(72) Inventor: **ZHANG, Quanshi**
**Shanghai 200240 (CN)**

(74) Representative: **Lavoix**
**Bayerstraße 83**
**80335 München (DE)**

(54) **METHOD FOR DETERMINING SPARSE INTERACTION EFFECT OF BLACK-BOX ARTIFICIAL INTELLIGENCE MODEL**

(57)    The present application relates to the technical field of machine learning. Disclosed are a method and system for interpreting a sparse interaction effect modeled by a black-box artificial intelligence model. The method and system can automatically analyze an interactive distribution modeled by a model. The implementation of the method and system comprises the following steps: providing data that needs to be assessed; using a black-box model to perform prediction on the data, so as to obtain a prediction result of the model; on the basis of an output of the black-box model, modeling the interaction effect between input units of samples, calculating the interaction intensity between combinations formed by the input units, and expressing the black-box model as an "AND addition relationships" and an "OR addition relationships" between the combinations of the input units; and performing optimization, such that the "AND addition relationships" and the "OR addition relationships" are sparser. The advantages of the present invention lie in that a quantification method for interpreting the interaction modeled by a black-box artificial intelligence model is provided, and in comparison with previous research, a sparser and concise interactive interpretation can be obtained.

FIG. 1

**Description**

TECHNICAL FIELD

The present invention relates to the technical field of machine learning, and specifically to a method and system for interpreting the sparse interaction effect modeled by a black-box artificial intelligence model.

BACKGROUND ART

Currently, deep learning has been widely applied in various fields and has demonstrated powerful performance, but it is difficult for users and researchers to analyze the black-box nature of artificial intelligence models. In existing technologies, interaction-based interpretation methods can quantitatively analyze the interaction effect generated by various units and attribute combinations in the model input while ensuring reliability, but they cannot guarantee the sparsity and conciseness of the interpretation results. However, sparse and concise interpretation results are necessary conditions for the interpretability of artificial intelligence.

Therefore, how to reliably interpret the interaction effect modeled by a black-box model while ensuring its sparsity and conciseness is an urgent problem to be solved in the field of interpretability.

SUMMARY OF THE INVENTION

**An object of the present invention is to invent a method and system for interpreting the sparse interaction effect modeled by a black-box artificial intelligence model, which can automatically analyze the interaction distribution modeled by the model. The method includes the following steps:**

(1) Selecting a model
Select a black-box artificial intelligence model to be analyzed, which is a model that has been pre-trained on a certain dataset.
(2) Acquiring data to be assessed
Collect and preprocess the data to be assessed. The data can be in forms such as tabular data, images, text, speech, etc., but must be compatible with the model in step (1). The data to be assessed comprises a certain number of input units.
(3) Modeling the "AND addition relationships" and "OR addition relationships" between input units
Input the data to be assessed from step (2) into the model from step (1), and obtain the model output. Based on the output of the black-box model, model the interactive cooperative effects between the input units to obtain sets composed of different input units, and calculate the interaction intensity of each set. Express the black-box model as a combination of "AND addition relationships" and "OR addition relationships" between combinations of input units.
(4) Optimizing the combination of "AND addition relationships" and "OR addition relationships"

Based on the "AND addition relationships" and "OR addition relationships" described in step (3), optimize the combination of "AND addition relationships" and "OR addition relationships" to make the expression of both relationships more concise and sparser.

In a preferred embodiment, the step (1) further includes the following steps:
Based on a certain dataset, train a black-box artificial intelligence model to be used as the model to be analyzed. Optionally, the model can be a deep neural network.

In a preferred embodiment, the step (2) further includes the following sub-steps:

(a) Collect data to be analyzed. Optionally, if the model in step (1) can be used for image classification, the data to be analyzed may be an image.
(b) Preprocess the data to be analyzed. Optionally, the data to be analyzed can be down-sampled or up-sampled, normalized, etc., to adapt it to the aforementioned model input. In a preferred embodiment, the step (3) further includes the following sub-steps:

(3a) Calculate the output values of the black-box model for the aforementioned data to be analyzed under any masked condition;
(3b) Calculate the "AND-interaction" in the data to be analyzed as modeled by the black-box model;
(3c) Calculate the "OR-interaction" in the data to be analyzed as modeled by the black-box model.

In the aforementioned sub-step (3a), the black-box artificial intelligence model is denoted as v, and a data sample x to be analyzed comprises n input units, represented as a set N = {1,2,..., n}, wherein the number of input units is generally a positive integer greater than or equal to 5. Optionally, each dimension of the input data can be regarded as an input unit, or the input data may be divided into multiple regions, with each region being regarded as an input unit.

Any subset $S \subseteq N$ of the input units is referred to as a combination of input units. v(S) represents the output of the black-box model given a certain combination of input units S, with the input units in N\S being masked. Specifically, if the data to be analyzed is input to the model without any masking, the obtained output is denoted as v(N). If the data to be analyzed is input to the model with complete masking, the obtained output is denoted as v(ø).

When calculating the output v(S) of the black-box model on a certain combination of input units S, it is necessary to maintain the original input values of the sample to be analyzed for the input units contained in S, while replacing the input units in the complement of S, N\S, with a baseline value. Specifically, let the baseline value be b, each input unit of the masked sample $x_s$ is defined by the following formula:

$$(x_S)_i = \begin{cases} x_i & \text{if the i-th input unit is included in the combination of input units } S \\ b_i & \text{if the i-th input unit is not included in the combination of input units } S \end{cases}$$

Thus, v(S) can be calculated as the output value obtained by inputting the sample $x_s$ into the model. Optionally, the baseline value can be set to a mean value, a random value, or a zero value of the sample set, etc. Furthermore, the black-box model output v(S) calculated based on the baseline value b can be specifically denoted as v(S|b). It should be understood that, where no ambiguity arises, v(S|b) can be abbreviated as v(S).

In the aforementioned sub-step (3b), the "AND-interaction" is calculated to evaluate the contribution value of the AND relationship between any combination of input units to the output of the black-box model. The "AND-interaction" represents the additional effect produced for the black-box model output when the units in the combination are simultaneously triggered (i.e., not masked). It should be understood that in a black-box model, input units often do not contribute to the model's output individually, but rather interact with each other to influence the model's output.

Therefore, for $S \subseteq N$, $I^{AND}(S)$ is defined as the "AND-interaction" corresponding to the combination of input units S, such that $I^{AND}(S)$ is triggered and added to the output of the black-box model only when all input variables in S are triggered. Specifically, $I^{AND}(S)$ can be calculated using the following formula.

$$I^{AND}(S) = \sum_{L \subseteq S} (-1)^{s-l} v(L)$$

Wherein, s = |S| and l = |L|. Optionally, different "AND-interaction" values may be calculated based on different baseline values in step (2). The AND-interaction calculated based on baseline value b is denoted as $I^{AND}(S|b)$. It should be understood that, where no ambiguity arises, $I^{AND}(S|b)$ can be abbreviated as $I^{AND}(S)$.

The aforementioned "AND-interaction" satisfies that for any given combination of input units $T \subseteq N$, the output of the black-box model for this combination of input units, v(T), can be decomposed into the sum of all triggered AND-interactions $I^{AND}(S)$, as shown in the following formula.

$$\forall T \subseteq N, v(T) = \sum_{S \subseteq N} I^{AND}(S) \left[ \bigwedge_{i \in S} (e_T)_i \right] \Leftrightarrow v(T) = I^{AND}(\emptyset) + \sum_{\emptyset \neq S \subseteq T} I^{AND}(S)$$

where $e_T$ satisfies that when i E T, $(e_T)_i$ = 1, otherwise, $(e_T)_i$ = 0; $\bigwedge_{i \in S}(e_T)_i$ indicates whether all units in the combination of input units S are triggered, which is the result of performing an "AND" operation on the elements following the $\bigwedge$ symbol, i.e., $\bigwedge_{i \in S}(e_T)_i = \Pi_{i \in S}(e_T)_i$.

Furthermore, the calculation formula for the above AND-interaction can be equivalently expressed in the following form. Assuming $v = [v(S_1), v(S_2), \cdots, v(S_{2^n})] \in \mathbb{R}^{2^n}$ and $I^{AND} = [I^{AND}(S_1), I^{AND}(S_2), \cdots, I^{AND}(S_{2^n})] \in \mathbb{R}^{2^n}$, then there exists A E $\{0, 1, -1\}^{2n \times 2n}$ such that $I^{AND} = Av$.

In the aforementioned sub-step (3c), the "OR-interaction" is calculated to evaluate the contribution value of the OR relationship between any combination of input units to the output of the black-box model. The "OR-interaction" represents the additional effect produced for the black-box model output when at least one of the units in the combination is triggered (i.e., not masked). It should be understood that in a black-box model, input units often do not contribute to the model's output individually, but rather interact with each other to influence the model's output.

Therefore, for $S \subseteq N$, $I^{OR}(S)$ is defined as the "OR-interaction" corresponding to the combination of input units S,

such that $I^{OR}(S)$ is triggered and added to the output of the black-box model when at least one of the input variables in S is triggered. Specifically, $I^{OR}(S)$ can be calculated using the following formula.

$$I^{OR}(S) = \begin{cases} v(\emptyset), & S = \emptyset \\ -\sum_{L \subseteq S}(-1)^{s-l}v(N \backslash L), & S \neq \emptyset \end{cases}$$

Wherein, s = |S| and l = |L|. The aforementioned "OR-interaction" satisfies that for any given combination of input units $T \subseteq N$, the output of the black-box model for this combination of input units, v(T), can be decomposed into the sum of all triggered OR-interactions $I_{OR}(S)$, as shown in the following formula.

$$\forall T \subseteq N, v(T) = \sum_{S \subseteq N} I^{OR}(S)\left[\bigvee_{i \in S}(e_T)_i\right] \Leftrightarrow v(T) = I^{OR}(\emptyset) + \sum_{S: S \cap T \neq \emptyset} I^{OR}(S)$$

Wherein, $e_T$ satisfies that when $i \in T$, $(e_T)_i = 1$, otherwise, $(e_T)_i = 0$; $V_{i \in S}(e_T)_i$ indicates whether at least one of the units in the combination of input units S is triggered, which is the result of performing an "OR" operation on the elements following the V symbol, i.e., $V_{i \in S}(e_T)_i = 1 - \Pi_{i \in S}[1 - (e_T)_i]$.

Furthermore, the calculation formula for the above OR-interaction can be equivalently expressed in the following form.

$$\text{Assuming} = [v(S_1), v(S_2), \cdots, v(S_{2^n})] \in \mathbb{R}^{2^n} \quad \text{and}$$

$$I^{OR} = [I^{OR}(S_1), I^{OR}(S_2), \cdots, I^{OR}(S_{2^n})] \in \mathbb{R}^{2^n}$$, then there exists $B \in \{0, 1, -1\}^{2n \times 2n}$ such that $I^{OR} = Bv$.

In a preferred embodiment, the step (4) further includes the following sub-steps:

(4a) Based on the "AND-interaction" and "OR-interaction" from step (3), interpret the black-box model output as a combination of "AND addition relationships" and "OR addition relationships" between combinations of input units.
(4b) Based on the combination of "AND addition relationships" and "OR addition relationships" from sub-step (4a), further optimize the combination of "AND addition relationships" and "OR addition relationships" to make the expression of both relationships more concise and sparser.

In sub-step (4a), based on the "AND-interaction" and "OR-interaction" from step (3), the output v(T) of the black-box model for any combination of input units T is interpreted as a combination of "AND addition relationships" and "OR addition relationships". Optionally, based on different baseline values from step (3), the output v(T) of the black-box model can be interpreted as a combination of "AND addition relationships" and "OR addition relationships" based on different baseline values. Generally, assuming there are m different baseline values $b^{(1)}, ..., b^{(m)}$, the output v(T) of the black-box model for any combination of input units can be interpreted by the following formula.

$$\forall T \subseteq N, v(T) = \hat{I}^{AND}\left(\emptyset|b^{(1)}\right) + \sum_{\emptyset \neq S \subseteq N} \hat{I}^{AND}\left(S|b^{(1)}\right)\left[\bigwedge_{i \in S}(e_T)_i\right]$$

$$+ \quad \cdots$$

$$+ \hat{I}^{AND}\left(\emptyset|b^{(m)}\right) + \sum_{\emptyset \neq S \subseteq N} \hat{I}^{AND}\left(S|b^{(m)}\right)\left[\bigwedge_{i \in S}(e_T)_i\right]$$

$$+ \hat{I}^{OR}(\emptyset) + \sum_{\emptyset \neq S \subseteq N} \hat{I}^{OR}(S)\left[\bigvee_{i \in S}(e_T)_i\right]$$

Therefore, based on the above interpretation of the black-box model, the output v(N) of the model on the complete sample can be decomposed as $(N) = \Sigma_{S \subseteq N} \hat{I}^{AND}(S|b^{(1)}) + \cdots + \Sigma_{S \subseteq N} \hat{I}^{AND}(S|b^{(m)}) + \Sigma_{S \subseteq N} \hat{I}^{OR}(S)$. Wherein, the black-box model output v(N) is interpreted as the sum of effects of m groups of "AND-interactions", where each group of "AND-interactions" comprises $2^n$ "AND-interaction" effect $\hat{I}^{AND}(S|b), S \subseteq N$ within combinations of input units; and the sum of effects of one group of "OR-interactions", comprising $2^n$ "OR-interaction" effects $\hat{I}^{OR}(S), S \subseteq N$ within combinations of input units. Optionally, the aforementioned m kinds of different baseline values can be selected from mean values, random values, zero values, etc.

In sub-step (4b), to further obtain sparse interactions, the present invention aims to minimize the sum of the L -norms of all interactions, i.e.,

$$\min_{\hat{I}^{AND}_{b^{(1)}},\ldots,\hat{I}^{AND}_{b^{(m)}},\hat{I}^{OR}} \left\| \hat{I}^{AND}_{b^{(1)}} \right\|_1 + \cdots + \left\| \hat{I}^{AND}_{b^{(m)}} \right\|_1 + \left\| \hat{I}^{OR} \right\|_1$$

wherein, $\hat{I}^{AND}_b = [\hat{I}^{AND}(S_1|b), \hat{I}^{AND}(S_2|b), \cdots, \hat{I}^{AND}(S_{2^n}|b)] \in \mathbb{R}^{2^n},\ \hat{I}^{OR} =$

$[\hat{I}^{OR}(S_1), \hat{I}^{OR}(S_2), \cdots, \hat{I}^{OR}(S_{2^n})] \in \mathbb{R}^{2^n}$, and $\|\cdot\|_1$ denotes the $L_1$-norm of a vector. The m in the above formula is the number of m baseline values mentioned previously.

Optionally, when optimizing the above expression, $p^{(1)}, \ldots, p^{(m)}, \boldsymbol{p}^{(or)} \in \mathbb{R}^{2^n}$ can be defined, which satisfies that $p^{(1)} + \cdots + p^{(m)} + p^{(or)} = 0$. Here, $p^{(1)}, \ldots, p^{(m)}, p^{(or)}$ represent a partition of the neural network output v. And define $\boldsymbol{q} \in \mathbb{R}^{2^n}$, where q is a vector with small absolute values in each dimension, representing the deviation produced by interpreting the model output as "AND addition relationships" and "OR addition relationships". Make

$$\hat{I}^{AND}_{b^{(1)}} = A\left(\frac{1}{m+1}(\boldsymbol{v}+\boldsymbol{q}) + \boldsymbol{p}^{(1)}\right) \quad,\ldots,\qquad \hat{I}^{AND}_{b^{(m)}} = A\left(\frac{1}{m+1}(\boldsymbol{v}+\boldsymbol{q}) - \boldsymbol{p}^{(m)}\right),\quad \text{and}$$

$$\hat{I}^{OR} = B\left(\frac{1}{m+1}(\boldsymbol{v}+\boldsymbol{q}) + \boldsymbol{p}^{(or)}\right).$$ Then the above optimization problem can be transformed into the following form.

$$\min_{p^{(1)},\ldots,p^{(m)},p^{(or)},\boldsymbol{q}} \left\| \hat{I}^{AND}_{b^{(1)}} \right\|_1 + \cdots + \left\| \hat{I}^{AND}_{b^{(m)}} \right\|_1 + \left\| \hat{I}^{OR} \right\|_1$$

s. t.

$$|\mathbf{q}_i| < \tau_i$$

Wherein, $\tau_i$ is a predetermined threshold. Preferably, $\tau_i = 0.05 \times |v(N) - v(\varnothing)|$, and the value of m generally ranges from 1 to 10.

Specifically, in one embodiment, in the aforementioned sub-step (a), only one type of baseline value is selected, i.e., when m = 1, the output of the black-box model can be interpreted as a combination of "AND addition relationships" and "OR addition relationships" as shown in the formula below.

$$\forall T \subseteq N, v(T) = \hat{I}^{AND}(\varnothing) + \sum_{\varnothing \neq S \subseteq N} \hat{I}^{AND}(S)\left[\bigwedge_{i \in S}(e_T)_i\right]$$

$$+ \hat{I}^{OR}(\varnothing) + \sum_{\varnothing \neq S \subseteq N} \hat{I}^{OR}(S)\left[\bigvee_{i \in S}(e_T)_i\right]$$

Wherein, $\hat{I}^{AND}(S)$ represents the "AND-interaction" of the combination of input units S, and $\hat{I}^{OR}(S)$ represents the "OR-interaction" of the combination of input units S. Similarly, the black-box model output is interpreted as the sum of effects of $2^n$ "AND-interactions" between combinations of input units, and the sum of effects of $2^n$ "OR-interactions" between combinations of input units. Optionally, the aforementioned baseline value can be selected from one of mean value, random value, zero value, etc.

Further, in sub-step (b), to further obtain sparse interactions, the present invention aims to minimize the sum of the $L_1$-norms of all interactions, i.e.,

$$\min_{\hat{I}^{AND},\ \hat{I}^{OR}} \left\| \hat{I}^{AND} \right\|_1 + \left\| \hat{I}^{OR} \right\|_1,$$

Wherein,

$$\hat{\boldsymbol{I}}^{AND} = [\hat{I}^{AND}(S_1), \hat{I}^{AND}(S_2), \cdots, \hat{I}^{AND}(S_{2^n})] \in \mathbb{R}^{2^n},$$

$$\hat{\boldsymbol{I}}^{OR} = [\hat{I}^{OR}(S_1), \hat{I}^{OR}(S_2), \cdots, \hat{I}^{OR}(S_{2^n})] \in \mathbb{R}^{2^n}$$ , and $\|\cdot\|_1$ denotes the $L_1$-norm of a vector.

Optionally, when optimizing the above expression, one can define $\boldsymbol{p} \in \mathbb{R}^{2^n}$ and $\boldsymbol{q} \in \mathbb{R}^{2^n}$ . Let

$$\hat{\boldsymbol{I}}^{AND} = A\left(\frac{1}{2}(\boldsymbol{v} + \boldsymbol{q}) - \boldsymbol{p}\right)$$ , and $$\hat{\boldsymbol{I}}^{OR} = B\left(\frac{1}{2}(\boldsymbol{v} + \boldsymbol{q}) + \boldsymbol{p}\right)$$ . Then the above optimization problem can be transformed into the following form.

$$\min_{\boldsymbol{p},\boldsymbol{q}} \quad \left\|\hat{\boldsymbol{I}}^{AND}\right\|_1 + \left\|\hat{\boldsymbol{I}}^{OR}\right\|_1$$

S. t.

$$|\mathbf{q}_i| < \tau_i$$

Wherein, $\tau_i$ is a predetermined threshold. Preferably, $\tau_S = 0.05 \times |v(N) - v(\emptyset)|$.

In a preferred embodiment, the labeling of combinations of input units in the above step (3) and step (4) can further include the following steps:

The output v(N) corresponding to the input sample N can model $2^n$ AND-interactions $I^{AND}$ within combinations of input units and $2^n$ OR-interactions $I^{OR}$ within combinations of input units. The $2^n$ combinations of input units are labeled in the following manner.

For example, when n = 3, let N = {i, j, k}. Preferably, all combinations of input units can be labeled as shown in Table 1.

Table 1

| Label | $S_1$ | $S_2$ | $S_3$ | $S_4$ | $S_5$ | $S_6$ | $S_7$ | $S_8$ |
|---|---|---|---|---|---|---|---|---|
| Combination of Input Units | {ø} | {i} | {j} | {k} | {i, j} | {i, k) | {j, k} | {i, j, k} |

For example, when n = 5, let N = {i, j, k, 1, m}. Preferably, all combinations of input units can be labeled as shown in Table 2

Table 2

| Label | $S_1$ | $S_2$ | $S_3$ | $S_4$ | $S_5$ | $S_6$ | $S_7$ | $S_8$ |
|---|---|---|---|---|---|---|---|---|
| Combination of Input Units | {ø} | {i} | {i} | {k} | {l} | {m} | {i, j} | {i, k} |
| Label | $S_9$ | $S_{10}$ | $S_{11}$ | $S_{12}$ | $S_{13}$ | $S_{14}$ | $S_{15}$ | $S_{16}$ |
| Combination of Input Units | {i, l} | {i, m} | {j, k} | {j, l} | {j, m} | {k, l} | {k, m} | {l, m} |
| Label | $S_{17}$ | $S_{18}$ | $S_{19}$ | $S_{20}$ | $S_{21}$ | $S_{22}$ | $S_{23}$ | $S_{24}$ |
| Combination of Input Units | {i, j, k} | {i, j, l} | {i, j, m} | {i, k, l) | {i, k, m} | {i, l, m} | {j, k, l} | {j, k, m} |
| Label | $S_{25}$ | $S_{26}$ | $S_{27}$ | $S_{28}$ | $S_{29}$ | $S_{30}$ | $S_{31}$ | $S_{32}$ |
| Combination of Input Units | {j, l, m} | {k, l, m} | {i, j, k, l} | {i, j, k, m} | {i, j, l, m} | {i, k, l, m} | {j, k, l, m} | {i, j, k, l, m} |

A second aspect of the present invention provides a system for interpreting the sparse interaction effect modeled by a black-box artificial intelligence model, wherein it includes:

(1) An input module, configured to recieve a pre-trained black-box artificial intelligence model and a set of data to be analyzed.

(2) A calculation module, configured to, based on the model and data in the input module, calculate the "AND addition relationships" and "OR addition relationships" between the input units of the data as modeled by the model, then optimize the combination of "AND addition relationships" and "OR addition relationships" to make the expression of both relationships more concise and sparser.

(3) An output module, configured to output the combination of "AND addition relationships" and "OR addition relationships" optimized by the calculation module.

It should be understood that within the scope of the present invention, the various technical features described above and the various technical features specifically described below (e.g., in the embodiments) can be combined with each other to form new or preferred technical solutions. Due to space limitations, they are not exhaustively described herein.

Other features, objects, and advantages of the present invention will become more apparent from the detailed description of non-limiting embodiments with reference to the following drawings.

The main advantages of the present invention are:

(1) The present invention proposes a method and system capable of automatically analyzing the internal "AND addition relationships" and "OR addition relationships" of a black-box model;

(2) The method and system disclosed by the present invention can ensure the rigor of the interpretation results, that is, based on the "AND-interaction" and "OR-interaction" proposed in the present invention, the output of the black-box model can be accurately decomposed into the sum of interaction effects between different input units;

(3) The method and system disclosed by the present invention can ensure the conciseness of the interpretation results, that is, based on the optimization of "AND addition relationships" and "OR addition relationships" proposed in the present invention, a sparser and more concise interaction interpretation can be obtained;

(4) The method and system disclosed by the present invention have broad applicability and generality, i.e., they are applicable to most black-box models, including but not limited to deep neural networks.

This specification comprises numerous technical features distributed among various technical solutions. Listing all possible combinations of these technical features (i. e. , technical solutions) would make the specification too lengthy. To avoid this problem, the technical features disclosed in the above-mentioned invention content, the technical features disclosed in various embodiments and examples in the following text, and the technical features disclosed in the drawings can all be freely combined to form various new technical solutions (which should be considered as already disclosed in this specification), unless such combinations of technical features are technically infeasible. For example, if feature A+B+C is disclosed in one example and feature A+B+D+E is disclosed in another example, and features C and D are equivalent technical means that serve the same purpose, only one of them can be chosen for technical reasons and cannot be used simultaneously. Feature E can be combined with feature C from a technical perspective. Therefore, the A+B+C+D solution should not be considered as already disclosed because it is technically infeasible, while the A+B+C+E solution should be considered as already disclosed.

BRIEF DESCRIPTION OF THE DRAWINGS

The drawings required for describing the embodiments or the prior art will be briefly introduced below. It is obvious that the drawings in the following description are only some embodiments of the present invention, and for those ordinarily skilled in the art, other drawings can be obtained from these drawings without creative effort.

FIG. 1 is a schematic flowchart of a method for interpreting the sparse interaction effect modeled by a black-box artificial intelligence model according to a first embodiment of the present invention;

FIG. 2(a) is a schematic diagram of a sample to be analyzed and input variables according to the present invention.

FIG. 2(b) is the initial effect distribution of "AND addition relationships" and "OR addition relationships" obtained according to the present invention.

FIG. 2(c) is the final effect distribution of "AND addition relationships" and "OR addition relationships" optimized according to the present invention, where this result is based on tabular data;

FIG. 3 shows the effect values of some "AND-interactions" and "OR-interactions" optimized according to the present invention, where this result is based on tabular data.

FIG. 4(a) is a schematic diagram of a sample to be analyzed and input variables according to the present invention.

FIG. 4(b) is the initial effect distribution of "AND addition relationships" and "OR addition relationships" obtained according to the present invention.

FIG. 4(c) is the final effect distribution of "AND addition relationships" and "OR addition relationships" optimized according to the present invention, where this result is based on image data;

FIG. 5 shows the effect values of some "AND-interactions" and "OR-interactions" optimized according to the present invention, where this result is based on image data.

FIG. 6 is a schematic structural diagram of a system for interpreting the sparse interaction effect modeled by a black-box artificial intelligence model according to a second embodiment of the present invention.

DETAILED DESCRIPTION OF EMBODIMENTS

After careful and in-depth research, the inventors have for the first time developed a method and system for interpreting the sparse interaction effect modeled by a black-box artificial intelligence model.

General Method

Typically, the present invention includes the following steps:

(1) Select a model. Select a black-box artificial intelligence model to be analyzed, which is a model that has been pre-trained on a certain dataset.

(2) Obtain data to be assessed. Collect and preprocess the data to be assessed. The data can be in forms such as tabular data, images, text, speech, etc., but must be compatible with the model in step (1). The data to be assessed comprises a certain number of input units.

(3) Model the "AND addition relationship" and "OR addition relationships" between input units. Input the data to be assessed from step (2) into the model from step (1), and obtain the model output. Based on the output of the black-box model, model the interactive cooperative effects between the input units to obtain sets composed of different input units, and calculate the interaction intensity of each set. Express the black-box model as a combination of "AND addition relationships" and "OR addition relationships" between combinations of input units.

(4) Optimize the combination of "AND addition relationships" and "OR addition relationships". Based on the "AND addition relationships" and "OR addition relationships" described in step (3), optimize the combination of "AND addition relationships" and "OR addition relationships" to make the expression of both relationships more concise and sparser.

Embodiments

To make the objectives, technical solutions, and advantages of the present application clearer, the embodiments of the present application will be further described in detail below in conjunction with the accompanying drawings.

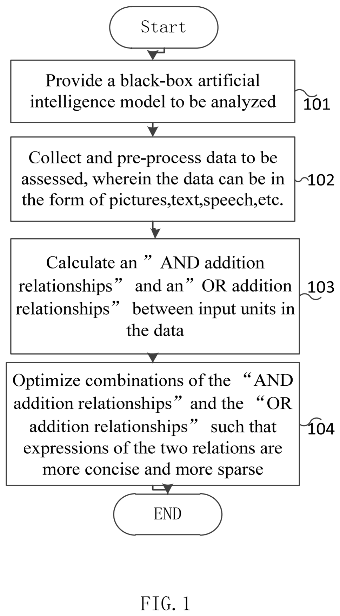

The first embodiment of the present invention relates to a method for interpreting the sparse interaction effect modeled by a black-box artificial intelligence model, the process of which is shown in FIG. 1, and the method includes the following steps: In step 101: Based on a certain dataset, train a black-box artificial intelligence model to be used as the model to be analyzed. Optionally, the model can be a deep neural network.

In one embodiment, the model is selected as a five-layer perceptron model (MLP-5) pre-trained on the UCI Wireless Indoor Localization dataset, which is a deep neural network; in another embodiment, the model is selected as a ResNet-18 model pre-trained on the CelebA dataset, which is also a deep neural network.

Then, proceed to step 102, which can be further divided into the following two sub-steps:

(a) Collect the data to be analyzed. Optionally, if the model in step (1) can be used for image classification, the data to be analyzed may be an image.

(b) Preprocess the data to be analyzed. Optionally, the data to be analyzed can be down-sampled or up-sampled, normalized, etc., to adapt it to the aforementioned model input.

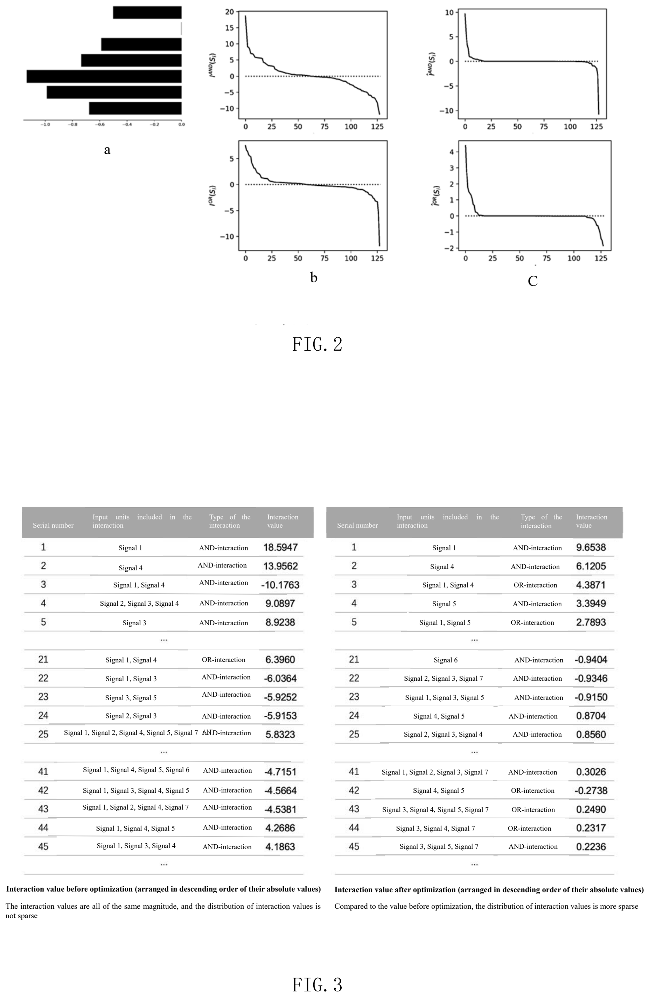

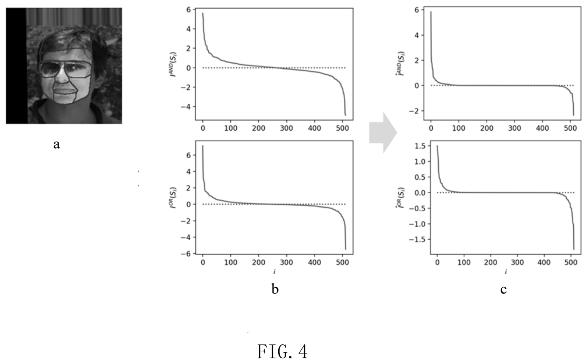

In one embodiment, as shown in FIG. 2 (left), the data is selected as any data from the UCI Wireless Indoor Localization dataset, comprising 7 input variables, representing the 1st to 7th WiFi signal intensity values, denoted as signal 1, signal 2, ..., signal 7; in another embodiment, as shown in FIG. 4 (left), the data is selected as any data from the CelebA dataset, divided into 9 input variables, i.e., hair, forehead, left eye, right eye, nose, left cheek, right cheek, mouth, and chin.

Then, proceed to step 103, which can be further divided into the following three sub-steps:

(a) Calculate the output values of the black-box model for the aforementioned data to be analyzed under any masked condition;

(b) Calculate the "AND-interaction" in the data to be analyzed as modeled by the black-box model;

(c) Calculate the "OR-interaction" in the data to be analyzed as modeled by the black-box model.

In the aforementioned sub-step (a), the black-box artificial intelligence model is denoted as $v$, and a data sample $x$

to be analyzed comprises n input units, represented as a set N = {1,2,..., n}, where the number of input units is generally from 5 to 20. Optionally, each dimension of the input data can be regarded as an input unit, or the input data may be divided into multiple regions, with each region regarded as an input unit.

Any subset $S \subseteq N$ of the input units is referred to as a combination of input units. v(S) represents the output of the black-box model given a certain combination of input units S, with the input units in N\S being masked. Specifically, if the data to be analyzed is input to the model without any masking, the obtained output is denoted as v(N). If the data to be analyzed is input to the model with complete masking, the obtained output is denoted as v(ø),

When calculating the output v(S) of the black-box model on a certain combination of input units S, it is necessary to maintain the original input values of the sample to be analyzed for the input units contained in S, while replacing the input units in the complement of S, N\S, with a baseline value. Specifically, let the baseline value be b, the values of each dimension of the masked sample $x_s$ are defined by the following formula:

$$x_{S_i} = \begin{cases} x_i & \text{if the i-th dimension of the input is included in the combination of input units } S \\ b_i & \text{if the i-th dimension of the input is not included in the combination of input units } S \end{cases}$$

Thus, v(S) can be calculated as the output value obtained by inputting the sample $x_s$ into the model. Optionally, the baseline value can be set to the mean of the sample set, a random value, a zero value, etc. Furthermore, the black-box model output v(S) calculated based on the baseline value b can be specifically denoted as v(S|b). It should be understood that, where no ambiguity arises, v(S|b) can be abbreviated as v(S). In one embodiment, the baseline value b is set to the mean value of the samples in the sample set.

In the aforementioned sub-step (b), the "AND-interaction" is calculated to evaluate the contribution value of the AND relationship between any combination of input units to the output of the black-box model. The "AND-interaction" represents the additional effect produced for the black-box model output when the units in the combination are simultaneously triggered (i.e., not masked). It should be understood that in a black-box model, input units often do not contribute to the model's output individually, but rather interact with each other to influence the model's output.

Therefore, for $S \subseteq N$, $I^{AND}(S)$ is defined as the "AND-interaction" corresponding to the combination of input units S, such that $I^{AND}(S)$ is triggered and added to the output of the black-box model only when all input variables in S are triggered. Specifically, $I^{AND}(S)$ can be calculated using the following formula.

$$I^{AND}(S) = \sum_{L \subseteq S} (-1)^{s-l} v(L)$$

Wherein, $s = |S|$ and $l = |L|$. Optionally, different "AND-interaction" values may be calculated based on different baseline values in step (2). The AND-interaction calculated based on baseline value b is denoted as $I^{AND}(S|b)$. It should be understood that, where no ambiguity arises, $I^{AND}(S \mid b)$ can be abbreviated as $I^{AND}(S)$.

The aforementioned "AND-interaction" satisfies that for any given combination of input units $T \subseteq N$, the output of the black-box model for this combination of input units, v(T), can be decomposed into the sum of all triggered AND-interactions $I^{AND}(S)$, as shown in the following formula.

$$\forall T \subseteq N, v(T) = \sum_{S \subseteq N} I^{AND}(S) \left[ \bigwedge_{i \in S} (e_T)_i \right] \Leftrightarrow v(T) = I^{AND}(\emptyset) + \sum_{\emptyset \neq S \subseteq T} I^{AND}(S)$$

where $e_T$ satisfies that when i ∈ T, $(e_T)_i = 1$, otherwise, $(e_T)_i = 0$; $\bigwedge_{i \in S}(e_T)_i$ indicates whether all units in the combination of input units S are triggered, which is the result of performing an "AND" operation on the elements following the $\wedge$ symbol, i.e., $\bigwedge_{i \in S}(e_T)_i = \Pi_{i \in S}(e_T)_i$.

Furthermore, the calculation formula for the above AND-interaction can be equivalently expressed in the following form. Assuming $v = [v(S_1), v(S_2), \cdots, v(S_{2^n})] \in \mathbb{R}^{2^n}$ and $\mathbf{I^{AND}} = [I^{AND}(S_1), I^{AND}(S_2), \cdots, I^{AND}(S_{2^n})] \in \mathbb{R}^{2^n}$, then there exists A ∈ {0,1, -1}$^{2^n \times 2^n}$ such that $\mathbf{I^{AND}} = Av$.

In the aforementioned sub-step (c), the "OR-interaction" is calculated to evaluate the contribution value of the OR relationship between any combination of input units to the output of the black-box model. The "OR-interaction" represents the additional effect produced for the black-box model output when at least one of the units in the combination is triggered (i.e., not masked). It should be understood that in a black-box model, input units often do not contribute to the model's output individually, but rather interact with each other to influence the model's output.

Therefore, for $S \subseteq N$, $I^{OR}(S)$ is defined as the "OR-interaction" corresponding to the combination of input units S, such that $I^{OR}(S)$ is triggered and added to the output of the black-box model when at least one of the input variables in S is triggered. Specifically, $I^{OR}(S)$ can be calculated using the following formula.

$$I^{OR}(S) = \begin{cases} v(\emptyset), & S = \emptyset \\ -\sum_{L \subseteq S}(-1)^{s-l}v(N\backslash L), & S \neq \emptyset \end{cases}$$

Wherein, $s = |S|$ and $l = |L|$. The aforementioned "OR-interaction" satisfies that for any given combination of input units $T \subseteq N$, the output of the black-box model for this combination of input units, $v(T)$, can be decomposed into the sum of all triggered OR-interactions $I_{OR}(S)$, as shown in the following formula.

$$\forall T \subseteq N, v(T) = \sum_{S \subseteq N} I^{OR}(S)\left[\bigvee_{i \in S}(e_T)_i\right] \Leftrightarrow v(T) = I^{OR}(\emptyset) + \sum_{S:S \cap T \neq \emptyset} I^{OR}(S)$$

Wherein, $e_T$ satisfies that when $i \in T$, $(e_T)_i = 1$, otherwise, $(e_T)_i = 0$; $V_{i \in S}(e_T)_i$ indicates whether at least one of the units in the combination of input units S is triggered, which is the result of performing an "OR" operation on the elements following the V symbol, i.e., $V_{i \in S}(e_T)_i = 1 - \Pi_{i \in S}[1 - (e_T)_i]$.

Furthermore, the calculation formula for the above OR-interaction can be equivalently expressed in the following form. Assuming $\boldsymbol{v} = [v(S_1), v(S_2), \cdots, v(S_{2^n})] \in \mathbb{R}^{2^n}$ and

$\boldsymbol{I}^{OR} = [I^{OR}(S_1), I^{OR}(S_2), \cdots, I^{OR}(S_{2^n})] \in \mathbb{R}^{2^n}$ , then there exists $B \in \{0, 1, -1\}^{2n \times 2n}$ such that $I^{OR} = Bv$.

In one embodiment of the present invention, based on the MLP-5 model from step 101, the values of "AND-interaction" and "OR-interaction" are calculated respectively using the "AND-interaction" and "OR-interaction" calculation formulas. As shown in FIG. 2 (middle), a distribution graph of the "AND-interaction" effect and "OR-interaction" effect for different combinations of input units, arranged in descending order, is displayed. FIG. 3 (left) shows the effect values of some "AND-interactions" and "OR-interactions", with the values in the figure arranged in descending order of their absolute values. (This embodiment is based on tabular data)

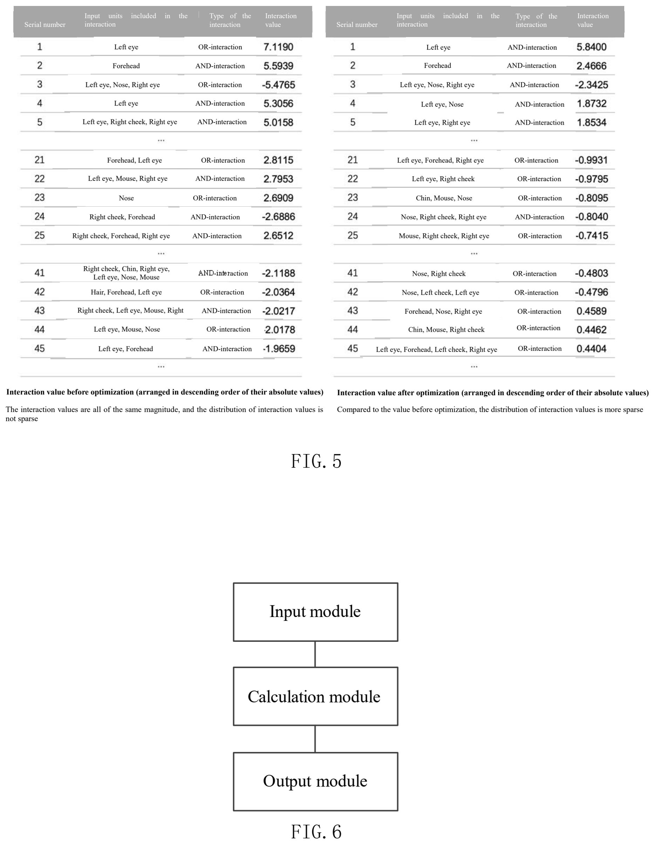

In another embodiment of the present invention, based on the ResNet-34 model from step 101, the values of "AND-interaction" and "OR-interaction" are calculated respectively using the "AND-interaction" and "OR-interaction" calculation formulas. As shown in FIG. 4 (middle), a distribution graph of the "AND-interaction" effect and "OR-interaction" effect for different combinations of input units, arranged in descending order, is displayed. FIG. 5 (left) shows the effect values of some "AND-interactions" and "OR-interactions", with the values in the figure arranged in descending order of their absolute values. (This embodiment is based on image data)

Then, proceed to step 104, which can be further divided into the following sub-steps:

(a) Based on the "AND-interaction" and "OR-interaction" from step (3), interpret the black-box model output as a combination of "AND addition relationships" and "OR addition relationships" between combinations of input units.
(b) Based on the combination of "AND addition relationships" and "OR addition relationships" from sub-step (a), further optimize the combination of "AND addition relationships" and "OR addition relationships" to make the expression of both relationships more concise and sparser.

In sub-step (a), based on the "AND-interaction" and "OR-interaction" from step (3), the output $v(T)$ of the black-box model for any combination of input units T is interpreted as a combination of "AND addition relationships" and "OR addition relationships". In this embodiment, in the aforementioned sub-step (a), only one type of baseline value is selected, and the output of the black-box model is interpreted as a combination of "AND addition relationships" and "OR addition relationships" as shown in the formula below.

$$\forall T \subseteq N, v(T) = \hat{I}^{AND}(\emptyset) + \sum_{\emptyset \neq S \subseteq N} \hat{I}^{AND}(S)\bigwedge_{i \in S}(e_T)_i$$

$$+ \hat{I}^{OR}(\emptyset) + \sum_{\emptyset \neq S \subseteq N} \hat{I}^{OR}(S)\bigvee_{i \in S}(e_T)_i$$

Wherein, $\hat{I}^{AND}(S)$ *represents* the "AND-interaction" of the combination of input units S, and $\hat{I}^{OR}(S)$ represents the "OR-interaction" of the combination of input units S. Similarly, the black-box model output is interpreted as the sum of

effects of $2^n$ "AND-interactions" between combinations of input units, and the sum of effects of $2^n$ "OR-interactions" between combinations of input units. Optionally, the aforementioned baseline value can be selected from one of mean value, random value, zero value, etc.

Further, in sub-step (b), to further obtain sparse interactions, the present invention aims to minimize the sum of the $L_1$-norms of all interactions, i.e.,

$$\min_{\hat{I}^{AND}, \hat{I}^{OR}} \left\| \hat{I}^{AND} \right\|_1 + \left\| \hat{I}^{OR} \right\|_1,$$

Wherein, $\hat{I}^{AND} = [\hat{I}^{AND}(S_1), \hat{I}^{AND}(S_2), \cdots, \hat{I}^{AND}(S_{2^n})] \in \mathbb{R}^{2^n}$,

$\hat{I}^{OR} = [\hat{I}^{OR}(S_1), \hat{I}^{OR}(S_2), \cdots, \hat{I}^{OR}(S_{2^n})] \in \mathbb{R}^{2^n}$, and $\|\cdot\|_1$ denotes the $L_1$-norm of a vector. Optionally, when optimizing the above expression, one can define $p \in \mathbb{R}^{2^n}$ and $q \in \mathbb{R}^{2^n}$. Let $\hat{I}^{AND} = A\left(\frac{1}{2}(v+q) - p\right)$ and

$\hat{I}^{OR} = B\left(\frac{1}{2}(v+q) + p\right)$. Then the above optimization problem can be transformed into the following form.

$$\min_{p,q,\alpha^{(1)},\ldots,\alpha^{(m)}} \left\| \hat{I}^{AND} \right\|_1 + \left\| \hat{I}^{OR} \right\|_1$$

s. t.

$$|q_i| < \tau_i$$

Wherein, $\tau_i$ is a predetermined threshold. In this embodiment, $\tau_S = 0.05 \times |v(N)|$.

In one embodiment of the present invention, the "AND addition relationships" and "OR addition relationships" calculated in FIG. 2 (middle) are optimized based on the aforementioned method to obtain sparser interaction effects. As shown in FIG. 2 (right), the figure displays a distribution graph of the "AND-interaction" effect and "OR-interaction" effect for different combinations of input units, arranged in descending order. Compared to the results in FIG. 2 (middle), the effect distributions of "AND-interaction" and "OR-interaction" are sparser. FIG. 3 (right) shows the effect values of some "AND-interactions" and "OR-interactions", arranged in descending order of their absolute values. Compared to FIG. 3 (left), the sparsity of "AND-interaction" and "OR-interaction" is also improved.

In another embodiment of the present invention, the "AND addition relationships" and "OR addition relationships" calculated in FIG. 4 (middle) are optimized based on the aforementioned method to obtain sparser interaction effects. As shown in FIG. 4 (right), the figure displays a distribution graph of the "AND-interaction" effect and "OR-interaction" effect for different combinations of input units, arranged in descending order. Compared to the results in FIG. 4 (middle), the effect distributions of "AND-interaction" and "OR-interaction" are sparser. FIG. 5 (right) shows the effect values of some "AND-interactions" and "OR-interactions", arranged in descending order of their absolute values. Compared to FIG. 5 (left), the sparsity of "AND-interaction" and "OR-interaction" is also improved.

The second embodiment of the present invention relates to a system for interpreting the sparse interaction effect modeled by a black-box artificial intelligence model, the structure of which is shown in FIG. 6, and the system includes:

(1) An input module, configured to receive a pre-trained black-box artificial intelligence model and a set of data to be analyzed.
(2) A calculation module, configured to, based on the model and data in the input module, calculate the "AND addition relationships" and "OR addition relationships" between the input units of the data as modeled by the model, and optimize the combination of "AND addition relationships" and "OR addition relationships" to make the expression of both relationships more concise and sparser.
(3) An output module, configured to output the combination of "AND addition relationships" and "OR addition relationships" optimized by the calculation module.

It should be noted that a person skilled in the art should understand that the implementation functions of each module shown in the embodiment of the system for interpreting the sparse interaction effect modeled by a black-box artificial intelligence model can be understood by referring to the relevant description of the method for interpreting the sparse interaction effect modeled by a black-box artificial intelligence model. The functions of each module shown in the embodiment of the system for interpreting the sparse interaction effect modeled by a black-box artificial intelligence model can be realized by a program (executable instructions) running on a processor, or by specific logic circuits. If the system for interpreting the sparse interaction effect modeled by a black-box artificial intelligence model in the embodiments of the present invention is implemented in the form of a software functional module and sold or used as an independent product, it can also be stored in a computer-readable storage medium. Based on this understanding, the technical solution of the embodiments of the present invention, in essence, or the part that contributes to the prior art, can be embodied in the form of a software product. The computer software product is stored in a storage medium and includes several instructions to cause a computer device (which can be a personal computer, a server, or a network device, etc.) to execute all or part of the method of each embodiment of the present invention. The aforementioned storage medium includes: a USB flash drive, a removable hard disk, a read-only memory (ROM), a magnetic disk, or an optical disc, and other media that can store program codes. Thus, the embodiments of the present invention are not limited to any specific combination of hardware and software.

Accordingly, an embodiment of the present invention also provides a computer-readable storage medium, in which computer-executable instructions are stored, and the computer-executable instructions are executed by a processor to implement the method embodiments of the present invention. The computer-readable storage medium includes permanent and non-permanent, removable and non-removable media, which can implement information storage by any method or technology. The information can be computer-readable instructions, data structures, program modules, or other data. Examples of computer storage media include, but are not limited to, phase-change memory (PRAM), static random-access memory (SRAM), dynamic random-access memory (DRAM), other types of random-access memory (RAM), read-only memory (ROM), electrically erasable programmable read-only memory (EEPROM), flash memory or other memory technologies, compact disc read-only memory (CD-ROM), digital versatile discs (DVD) or other optical storage, magnetic cassettes, magnetic tape, magnetic disk storage or other magnetic storage devices, or any other non-transitory medium that can be used to store information accessible by a computing device. As defined herein, computer-readable storage media do not include transitory computer-readable media, such as modulated data signals and carrier waves.

In addition, an embodiment of the present invention also provides a system for interpreting the sparse interaction effect modeled by a black-box artificial intelligence model, which includes a memory for storing computer-executable instructions, and a processor; the processor is used to execute the computer-executable instructions in the memory to implement the steps in the above method embodiments. The processor can be a central processing unit (CPU), or it can be other general-purpose processors, digital signal processors (DSP), application-specific integrated circuits (ASIC), etc. The aforementioned memory can be a read-only memory (ROM), a random-access memory (RAM), a flash memory, a hard disk, or a solid-state drive, etc. The steps of the methods disclosed in the embodiments of the present invention can be directly embodied as being executed by a hardware processor, or by a combination of hardware and software modules in the processor.

It should be noted that in the inventive document of this patent, relational terms such as first and second are only used to distinguish one entity or operation from another entity or operation, and do not necessarily require or imply any such actual relationship or order between these entities or operations. Moreover, the terms "include," "comprise," or any other variant thereof are intended to cover a non-exclusive inclusion, such that a process, method, article, or device that includes a series of elements not only includes those elements, but also includes other elements not explicitly listed, or elements inherent to such process, method, article, or device. Without more constraints, an element preceded by "includes a..." does not preclude the existence of additional identical elements in the process, method, article, or device that includes the element. In the inventive document of this patent, if an action is mentioned to be performed according to an element, it means that the action is performed at least according to that element, which includes two situations: performing the action only according to that element, and performing the action according to that element and other elements. Expressions such as multiple, many times, various types include two, twice, two types, and more than two, more than twice, more than two types.

All documents mentioned in the present invention are considered to be incorporated in their entirety into the disclosure of the present invention, so that they can serve as a basis for modification if necessary. In addition, it should be understood that the above are only preferred embodiments of this specification and are not intended to limit the protection scope of this specification. Any modification, equivalent replacement, improvement, etc., made within the spirit and principles of one or more embodiments of this specification should be included within the protection scope of one or more embodiments of this specification.

## Claims

1.    A method for measuring sparse interaction effects of a black-box artificial intelligence model, comprising the following steps:

(1) Providing a model

Providing a black-box artificial intelligence model to be analyzed, wherein the black-box artificial intelligence model comprises an artificial intelligence model pre-trained on a certain dataset;

(2) Obtaining data to be assessed

Based on the black-box artificial intelligence model, obtaining data to be assessed that is compatible with the artificial intelligence model, wherein the data to be assessed comprises n input units, where n is a positive integer $\geq 4$; wherein step (1) and step (2) can be interchanged or performed simultaneously;

(3) Calculating "AND-interaction" and "OR-interaction" between the input units Inputting the data to be assessed into the black-box artificial intelligence model, and obtaining the output of the black-box artificial intelligence model; based on the output of the black-box artificial intelligence model, modeling the interactive cooperative effects between the input units to obtain sets composed of different input units, denoted as combination of input units S (or assessment set S); and calculating the "AND-interaction" and "OR-interaction" of each combination of input units S;

(4) Measuring the sparse interaction effects

Based on the "AND-interaction" and "OR-interaction" between the combinations of input units S obtained in step (3), calculating the "AND addition relationships" and "OR addition relationships" between all combinations of input units S, and expressing the black-box model output as a combination of "AND addition relationships" and "OR addition relationships" between the combinations of input units, and using it to interpret the sparse interaction effect of the black-box artificial intelligence model.

2. The method of claim 1, wherein the method further comprises:

(5) Optimizing the "AND addition relationships" and "OR addition relationships" such that the degree of sparsity of the combination of the "AND addition relationships" and "OR addition relationships" after optimization is increased, and using the optimized "AND addition relationships" and "OR addition relationships" to interpret the sparse interaction effect of the black-box artificial intelligence model.

3. The method of claim 1, wherein the "AND-interaction" $I^{AND}(S)$ in the step (3) is obtained by the following formula:

$$I^{AND}(S) = \sum_{L \subseteq S} (-1)^{s-l} v(L)$$

wherein, $s = |S|$ and $l = |L|$; s is the number of input units in a certain combination of input units S, denoted as $s = |S|$; 1 is the number of the input units in a combination of input units L, denoted as $1 = |L|$, the combination of input units L is any subset of the combination of input units S, the calculation method of v(L) in the formula is as follows, the n input variables are denoted as $N = \{1,2,...,n\}$, v(L) represents that in the data to be assessed, only the input units in the combination of input units L are retained, while other input units are masked to a baseline value b, the baseline value b is a vector with the same dimensionality as the data to be assessed, the baseline value b can be selected from the mean value, a random value or a zero value of the input sample set, etc.; the output value obtained by inputting the masked data to be assessed $X_L$ into the black-box model is denoted as v(L), specifically, each input unit of the masked the data to be assessed $x_L$ is defined by the following formula:

$$(x_S)_i = \begin{cases} x_i & \text{if the i-th input unit is included in the combination of input units } S \\ b_i & \text{if the i-th input unit is not included in the combination of input units } S \end{cases}.$$

4. The method of claim 1, wherein the "OR-interaction" $I^R(S)$ in the step (3) is obtained by the following formula:

$$I^{OR}(S) = \begin{cases} v(\emptyset), & S = \emptyset \\ -\sum_{L \subseteq S} (-1)^{s-l} v(N \setminus L), & S \neq \emptyset \end{cases}$$

wherein, $s = |S|$ and $1 = |L|$; s is the number of the input units in a certain the combination of input units S, denoted as $s = |S|$; 1 is the number of input units in a combination of input units L, denoted as $1 = |L|$, the combination of input units L is any subset of the combination of input units S.

5. The method of claim 1, wherein in the step (4), the output v(T) of the black-box model is interpreted as a combination of "AND addition relationships" and "OR addition relationships" through the following formula:

$$\forall T \subseteq N, v(T) = \hat{I}^{AND}\left(\emptyset | b^{(1)}\right) + \sum_{\emptyset \neq S \subseteq N} \hat{I}^{AND}\left(S | b^{(1)}\right)\left[\bigwedge_{i \in S}(e_T)_i\right]$$

$$+ \quad\quad\quad \ldots$$

$$+ \hat{I}^{AND}\left(\emptyset | b^{(m)}\right) + \sum_{\emptyset \neq S \subseteq N} \hat{I}^{AND}\left(S | b^{(m)}\right)\left[\bigwedge_{i \in S}(e_T)_i\right]$$

$$+ \hat{I}^{OR}(\emptyset) + \sum_{\emptyset \neq S \subseteq N} \hat{I}^{OR}(S)\left[\bigvee_{i \in S}(e_T)_i\right]$$

wherein, the black-box model output v(N) is interpreted as the sum of effects of m groups of "AND-interactions" and one group of "OR-interactions", $b_1$, ..., $b_m$ represent m baseline values, m is the number of baseline values, the m baseline values can be selected from mean values, random values and zero values, wherein each group of "AND-interaction" comprises $2^n$ "AND-interaction" effects $\hat{I}^{AND}(S|b), S \subseteq N$ within combinations of input units; wherein the one group of "OR-interaction" comprises $2^n$ "OR-interaction" effects $\hat{I}^{OR}(S), S \subseteq N$; the m different types of baseline values can be selected from mean values, random values and zero values; V in the formula represents "for all"; $e_S$ in the formula satisfies that when i E S, $(e_T)_i$ = 1, otherwise, $(e_T)_i$ = 0; $\Lambda_{i \in S}(e_T)_i$ *indicates* whether all units in the combination of input units S are triggered, which is the result of performing an "AND" operation on the elements following the $\Lambda$ symbol, i.e., $\Lambda_{i \in S}(e_T)_i = \Pi_{i \in S}(e_T)_i$; $V_{i \in S}(e_T)_i$ indicates whether at least one of the units in the combination of input units S is triggered, which is the result of performing an "OR" operation on the elements following the V symbol, i.e., $V_{i \in S}(e_T)_i = 1 = \Pi_{i \in S}[1 - (e_T)_i]$.

6. The method of claim 2, wherein in the step (5), a sparser interaction relationship is further obtained by the following formula:

$$\min_{\hat{I}^{AND}_{b^{(1)}}, \ldots, \hat{I}^{AND}_{b^{(m)}}, \hat{I}^{OR}} \left\|\hat{I}^{AND}_{b^{(1)}}\right\|_1 + \cdots + \left\|\hat{I}^{AND}_{b^{(m)}}\right\|_1 + \left\|\hat{I}^{OR}\right\|_1$$

wherein, $\hat{I}^{AND}_b = [\hat{I}^{AND}(S_1|b), \hat{I}^{AND}(S_2|b), \cdots, \hat{I}^{AND}(S_{2^n}|b)] \in R^{2^n}$, $\hat{I}^{OR} = [\hat{I}^{OR}(S_1), \hat{I}^{OR}(S_2), \cdots, \hat{I}^{OR}(S_{2^n})] \in R^{2^n}$, $\|\cdot\|_1$ represents the $L_1$-norm of a vector, the m in the above formula is the number of selected baseline values, the baseline values include the mean of the input sample set, a random value, a zero value.

7. The method of claim 6, wherein the formula as described in claim 6 can be simplified in the following way: one can define $p^{(1)}$, ..., $p^{(m)}$, $p^{(or)} \in \mathbb{R}^{2^n}$, satisfying $p^{(1)} + \cdots + p^{(m)} + p^{(or)} = 0$, the $p^{(1)}, \cdots, p^{(m)}, p^{(or)}$ represent a partition of the neural network output v; and define $q \in \mathbb{R}^{2^n}$, the q is a vector with small absolute values in each dimension, representing the deviation produced by interpreting the model output as "AND addition relationships" and "OR addition relationships"; let

$$\hat{I}^{AND}_{b^{(1)}} = A\left(\frac{1}{m+1}(v + q) + p^{(1)}\right), \ldots, \hat{I}^{AND}_{b^{(m)}} = A\left(\frac{1}{m+1}(v + q) - p^{(m)}\right)$$ and

$$\hat{I}^{OR} = B\left(\frac{1}{m+1}(v + q) + p^{(or)}\right)$$; then the above optimization problem can be transformed into the following form:

$$\min_{p^{(1)},\dots,p^{(m)},p^{(or)},q} \left\| \hat{I}_{b^{(1)}}^{AND} \right\|_1 + \cdots + \left\| \hat{I}_{b^{(m)}}^{AND} \right\|_1 + \left\| \hat{I}^{OR} \right\|_1$$

s.t.

$$|q_i| < \tau_i$$

Wherein, $\tau_i$ is a predetermined threshold; preferably, $\tau_i = 0.05 \times |v(N) - v(\emptyset)|$, and the value range of m is from 1 to 10.

8. The method of claim 1, wherein the step (3) also includes the following step:
calculating the output value of the black-box model when any of the input units of the data to be analyzed are masked.

9. The method of claim 1, wherein the data to be assessed is selected from the group consisting of: tabular data, images, text, speech, or a combination thereof.

10. A system for interpreting sparse interaction effect modeled by a black-box artificial intelligence model, comprising the following modules:

(1) an input module, configured to receive a pre-trained black-box artificial intelligence model and a set of data to be analyzed;
(2) a calculation module, configured to, based on the model and data in the input module, calculate the "AND addition relationships" and "OR addition relationships" between the input units of the data as modeled by the model, and optimize the combination of "AND addition relationships" and "OR addition relationships" to make the expression of both relationships more concise and sparser;
(3) an output module, configured to output the combination of "AND addition relationships" and "OR addition relationships" optimized by the calculation module.

Start

Provide a black-box artificial intelligence model to be analyzed — 101

Collect and pre-process data to be assessed, wherein the data can be in the form of pictures,text,speech,etc. — 102

Calculate an ″ AND addition relationships″ and an″ OR addition relationships″ between input units in the data — 103

Optimize combinations of the "AND addition relationships″ and the "OR addition relationships″ such that expressions of the two relations are more concise and more sparse — 104

END

FIG. 1

FIG. 2

| Serial number | Input units included in the interaction | Type of the interaction | Interaction value |
|---|---|---|---|
| 1 | Signal 1 | AND-interaction | 18.5947 |
| 2 | Signal 4 | AND-interaction | 13.9562 |
| 3 | Signal 1, Signal 4 | AND-interaction | -10.1763 |
| 4 | Signal 2, Signal 3, Signal 4 | AND-interaction | 9.0897 |
| 5 | Signal 3 | AND-interaction | 8.9238 |
| ... | | | |
| 21 | Signal 1, Signal 4 | OR-interaction | 6.3960 |
| 22 | Signal 1, Signal 3 | AND-interaction | -6.0364 |
| 23 | Signal 3, Signal 5 | AND-interaction | -5.9252 |
| 24 | Signal 2, Signal 3 | AND-interaction | -5.9153 |
| 25 | Signal 1, Signal 2, Signal 4, Signal 5, Signal 7 | AND-interaction | 5.8323 |
| ... | | | |
| 41 | Signal 1, Signal 4, Signal 5, Signal 6 | AND-interaction | -4.7151 |
| 42 | Signal 1, Signal 3, Signal 4, Signal 5 | AND-interaction | -4.5664 |
| 43 | Signal 1, Signal 2, Signal 4, Signal 7 | AND-interaction | -4.5381 |
| 44 | Signal 1, Signal 4, Signal 5 | AND-interaction | 4.2686 |
| 45 | Signal 1, Signal 3, Signal 4 | AND-interaction | 4.1863 |
| ... | | | |

**Interaction value before optimization (arranged in descending order of their absolute values)**

The interaction values are all of the same magnitude, and the distribution of interaction values is not sparse

| Serial number | Input units included in the interaction | Type of the interaction | Interaction value |
|---|---|---|---|
| 1 | Signal 1 | AND-interaction | 9.6538 |
| 2 | Signal 4 | AND-interaction | 6.1205 |
| 3 | Signal 1, Signal 4 | OR-interaction | 4.3871 |
| 4 | Signal 5 | AND-interaction | 3.3949 |
| 5 | Signal 1, Signal 5 | OR-interaction | 2.7893 |
| ... | | | |
| 21 | Signal 6 | AND-interaction | -0.9404 |
| 22 | Signal 2, Signal 3, Signal 7 | AND-interaction | -0.9346 |
| 23 | Signal 1, Signal 3, Signal 5 | AND-interaction | -0.9150 |
| 24 | Signal 4, Signal 5 | AND-interaction | 0.8704 |
| 25 | Signal 2, Signal 3, Signal 4 | AND-interaction | 0.8560 |
| ... | | | |
| 41 | Signal 1, Signal 2, Signal 3, Signal 7 | AND-interaction | 0.3026 |
| 42 | Signal 4, Signal 5 | OR-interaction | -0.2738 |
| 43 | Signal 3, Signal 4, Signal 5, Signal 7 | OR-interaction | 0.2490 |
| 44 | Signal 3, Signal 4, Signal 7 | OR-interaction | 0.2317 |
| 45 | Signal 3, Signal 5, Signal 7 | AND-interaction | 0.2236 |
| ... | | | |

**Interaction value after optimization (arranged in descending order of their absolute values)**

Compared to the value before optimization, the distribution of interaction values is more sparse

FIG. 3

FIG. 4

| Serial number | Input units included in the interaction | Type of the interaction | Interaction value |
|---|---|---|---|
| 1 | Left eye | OR-interaction | 7.1190 |
| 2 | Forehead | AND-interaction | 5.5939 |
| 3 | Left eye, Nose, Right eye | OR-interaction | -5.4765 |
| 4 | Left eye | AND-interaction | 5.3056 |
| 5 | Left eye, Right cheek, Right eye | AND-interaction | 5.0158 |
| ... | | | |
| 21 | Forehead, Left eye | OR-interaction | 2.8115 |
| 22 | Left eye, Mouse, Right eye | AND-interaction | 2.7953 |
| 23 | Nose | OR-interaction | 2.6909 |
| 24 | Right cheek, Forehead | AND-interaction | -2.6886 |
| 25 | Right cheek, Forehead, Right eye | AND-interaction | 2.6512 |
| ... | | | |
| 41 | Right cheek, Chin, Right eye, Left eye, Nose, Mouse | AND-interaction | -2.1188 |
| 42 | Hair, Forehead, Left eye | OR-interaction | -2.0364 |
| 43 | Right cheek, Left eye, Mouse, Right | AND-interaction | -2.0217 |
| 44 | Left eye, Mouse, Nose | OR-interaction | 2.0178 |
| 45 | Left eye, Forehead | AND-interaction | -1.9659 |
| ... | | | |

Interaction value before optimization (arranged in descending order of their absolute values)

The interaction values are all of the same magnitude, and the distribution of interaction values is not sparse

| Serial number | Input units included in the interaction | Type of the interaction | Interaction value |
|---|---|---|---|
| 1 | Left eye | AND-interaction | 5.8400 |
| 2 | Forehead | AND-interaction | 2.4666 |
| 3 | Left eye, Nose, Right eye | AND-interaction | -2.3425 |
| 4 | Left eye, Nose | AND-interaction | 1.8732 |
| 5 | Left eye, Right eye | AND-interaction | 1.8534 |
| ... | | | |
| 21 | Left eye, Forehead, Right eye | OR-interaction | -0.9931 |
| 22 | Left eye, Right cheek | OR-interaction | -0.9795 |
| 23 | Chin, Mouse, Nose | OR-interaction | -0.8095 |
| 24 | Nose, Right cheek, Right eye | AND-interaction | -0.8040 |
| 25 | Mouse, Right cheek, Right eye | OR-interaction | -0.7415 |
| ... | | | |
| 41 | Nose, Right cheek | OR-interaction | -0.4803 |
| 42 | Nose, Left cheek, Left eye | OR-interaction | -0.4796 |
| 43 | Forehead, Nose, Right eye | OR-interaction | 0.4589 |
| 44 | Chin, Mouse, Right cheek | OR-interaction | 0.4462 |
| 45 | Left eye, Forehead, Left cheek, Right eye | OR-interaction | 0.4404 |
| ... | | | |

Interaction value after optimization (arranged in descending order of their absolute values)

Compared to the value before optimization, the distribution of interaction values is more sparse

FIG. 5

Input module

Calculation module

Output module

FIG. 6

## INTERNATIONAL SEARCH REPORT

| | International application No. |
|---|---|
| | **PCT/CN2024/088822** |

**A. CLASSIFICATION OF SUBJECT MATTER**

G06N3/04(2023.01)i; G06F30/27(2020.01)i; G06N20/00(2019.01)i; G06N3/08(2023.01)i; G06F111/10(2020.01)i

According to International Patent Classification (IPC) or to both national classification and IPC

**B. FIELDS SEARCHED**

Minimum documentation searched (classification system followed by classification symbols)

IPC:G06N G06F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 黑盒, 模型, 人工智能, 神经网络, 稀疏, 解释, 与, 或, 与加, 或加, 关系; black box, model, artificial intelligence, neural network, sparse, interpretation, AND, OR, AND 1W Add, OR 1W Add, relationship

**C. DOCUMENTS CONSIDERED TO BE RELEVANT**

| Category* | Citation of document, with indication, where appropriate, of the relevant passages | Relevant to claim No. |
|---|---|---|
| A | CN 114462291 A (SHANGHAI JIAO TONG UNIVERSITY) 10 May 2022 (2022-05-10) claims 1-2 | 1-10 |
| A | CN 113191441 A (BEIJING INSTITUTE OF TECHNOLOGY) 30 July 2021 (2021-07-30) entire document | 1-10 |
| A | CN 113518999 A (SIEMENS AG) 19 October 2021 (2021-10-19) entire document | 1-10 |
| A | CN 115457365 A (BEIJING BAIDU NETCOM SCIENCE AND TECHNOLOGY CO., LTD.) 09 December 2022 (2022-12-09) entire document | 1-10 |
| A | US 2022172050 A1 (UMNAI LIMITED) 02 June 2022 (2022-06-02) entire document | 1-10 |
| A | US 2022405531 A1 (ETSY, INC.) 22 December 2022 (2022-12-22) entire document | 1-10 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **21 June 2024** | **27 June 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/088822**

| Patent document cited in search report | | | Publication date (day/month/year) | Patent family member(s) | | | Publication date (day/month/year) |
|---|---|---|---|---|---|---|---|
| CN | 114462291 | A | 10 May 2022 | None | | | |
| CN | 113191441 | A | 30 July 2021 | None | | | |
| CN | 113518999 | A | 19 October 2021 | EP | 3918524 | A1 | 08 December 2021 |
| | | | | US | 2022172146 | A1 | 02 June 2022 |
| | | | | EP | 3709222 | A1 | 16 September 2020 |
| | | | | WO | 2020182706 | A1 | 17 September 2020 |
| CN | 115457365 | A | 09 December 2022 | US | 2024104906 | A1 | 28 March 2024 |
| US | 2022172050 | A1 | 02 June 2022 | WO | 2022101515 | A1 | 19 May 2022 |
| | | | | EP | 4244767 | A1 | 20 September 2023 |
| US | 2022405531 | A1 | 22 December 2022 | EP | 4356317 | A1 | 24 April 2024 |
| | | | | WO | 2022265782 | A1 | 22 December 2022 |

Form PCT/ISA/210 (patent family annex) (July 2022)